Europäisches Patentamt

European Patent Office

Office européen des brevets

(19)

(11) **EP 0 706 058 A1**

(12) **EUROPÄISCHE PATENTANMELDUNG**

(43) Veröffentlichungstag:
    **10.04.1996 Patentblatt 1996/15**

(51) Int. Cl.⁶: **G01R 33/54**, G01R 33/561,
    G01R 33/565

(21) Anmeldenummer: **95202622.7**

(22) Anmeldetag: **29.09.1995**

(84) Benannte Vertragsstaaten:
    **DE FR GB NL**

(30) Priorität: **04.10.1994 DE 4435464**

(71) Anmelder:
    • **Philips Patentverwaltung GmbH**
      **D-22335 Hamburg (DE)**
    Benannte Vertragsstaaten:
    **DE**

• **PHILIPS ELECTRONICS N.V.**
  **NL-5621 BA  Eindhoven (NL)**
  Benannte Vertragsstaaten:
  **FR GB NL**

(72) Erfinder: **Rasche, Volker,**
    **c/o Philips Patentverwaltung GmbH**
    **D-22335 Hamburg (DE)**

(74) Vertreter: **Hartmann, Heinrich, Dipl.-Ing. et al**
    **Philips Patentverwaltung GmbH,**
    **Röntgenstrasse 24**
    **D-22335 Hamburg (DE)**

(54) **Multislice-MR-Verfahren**

(57)    Die Erfindung betrifft ein MR-Verfahren mit einer Anzahl von Zyklen

-   wobei in jedem Zyklus nacheinander in mehreren, im Abstand voneinander befindlichen, jeweils eine Gruppe bildenden Meßschichten die Kernmagnetisierung angeregt und die unter dem Einfluß wenigstens eines Gradienten-Magnetfeldes erzeugten MR-Signale erfaßt werden,
-   wobei die durch verschiedene Zyklen angeregten Gruppen von Meßschichten gegeneinander einen räumlichen Versatz aufweisen, der kleiner ist als der Abstand der durch einen Zyklus angeregten Meßschichten
-   wobei von Zyklus zu Zyklus die Gradienten-Magnetfelder variiert werden
-   und wobei die Kernmagnetisierungsverteilung in einer Rekonstruktionsschicht aus den in den unterschiedliche Zyklen erfaßten MR-Signalen von räumlich benachbarten und beiderseits der Rekonstruktionsschicht befindlichen Meßschichten rekonstruiert wird.

Bei einem derartigen Multislice-Verfahren ergibt sich eine verbesserte Rekonstruktion dadurch, daß die Richtung des Gradienten des während der Erfassung des MR-Signals wirksamen Gradienten-Magnetfeldes von Zyklus zu Zyklus so variiert wird, daß sich die während aller Zyklen gegebenen Richtungen auf einen Winkelbereich von 360° aufteilen, wobei der Richtungsunterschied umso größer ist, je größer der Versatz zwischen den Gruppen von Meßschichten ist, die den Zyklen zugeordnet sind

-   und daß die MR-Signale von Meßschichten, die einen geringen Abstand von der Rekonstruktionsschicht haben, mit einem höheren Gewichtungsfaktor in die Rekonstruktion eingehen als die MR-Signale von Meßschichten, die von der Rekonstruktionsschicht einen größeren Abstand haben.

FIG. 2

## Beschreibung

Die Erfindung betrifft ein MR-Verfahren mit einer Anzahl von Zyklen

- wobei in jedem Zyklus nacheinander in mehreren, im Abstand voneinander befindlichen, jeweils eine Gruppe bildenden Meßschichten die Kernmagnetisierung angeregt und die unter dem Einfluß wenigstens eines Gradienten-Magnetfeldes erzeugten MR-Signale erfaßt werden,
- wobei die durch verschiedene Zyklen angeregten Gruppen von Meßschichten gegeneinander einen räumlichen Versatz aufweisen, der kleiner ist als der Abstand der durch einen Zyklus angeregten Meßschichten
- wobei von Zyklus zu Zyklus die Gradienten-Magnetfelder variiert werden
- und wobei die Kernmagnetisierungsverteilung in einer Rekonstruktionsschicht aus den in den unterschiedliche Zyklen erfaßten MR-Signalen von räumlich benachbarten und beiderseits der Rekonstruktionsschicht befindlichen Meßschichten rekonstruiert wird

sowie eine Anordnung zur Durchführung dieses Verfahrens.

Multislice-MR-Verfahren haben den Vorteil, daß man die MR-Daten von einer Anzahl paralleler Schichten praktisch in der gleichen Zeit gewinnen kann, die man auch für die Erfassung der MR-Daten einer einzigen Schicht benötigt. Die Schichten, die innerhalb eines Zyklus nacheinander angeregt werden, müssen dabei einen Abstand voneinander haben, um zu vermeiden, daß die Kernmagnetisierung in einer Schicht innerhalb eines Zyklus mehrmals angeregt wird. Dies führt bei herkömmlichen Multislice-MR-Verfahren dazu, daß man die Kernmagnetisierungsverteilung in den Lücken zwischen den Schichten nicht rekonstruieren kann.

Diesen Nachteil vermeidet das eingangs genannte MR-Verfahren, das aus der DE-PS 41 37 217 (= US-PS 5,298,862) bekannt ist. Von Zyklus zu Zyklus werden dabei nämlich geringfügig gegeneinander versetzte Gruppen von Meßschichten angeregt, wobei der Versatz dem Abstand zweier Meßschichten innerhalb einer Gruppe, dividiert durch die Zahl der Zyklen entspricht. Die Rekonstruktion der Kernmagnetisierungsverteilung in einer Schicht, der Rekonstruktionsschicht, erfolgt demgemäß mit MR-Signalen, die aus in unterschiedlichen Zyklen angeregten und gegeneinander räumlich leicht versetzten Schichten gewonnen wurden, d.h., die Kernmagnetisierungsverteilung in der Rekonstruktionsschicht entspricht dem Mittelwert der Kernmagnetisierungsverteilung in den räumlich leicht gegeneinander versetzten und einander überlappenden Meßschichten.

Bei dem bekannten Verfahren wird von Zyklus zu Zyklus das zwischen der Anregung der Kernmagnetisierung in einer Meßschicht und dem Erfassen des MR-Signals aus dieser Meßschicht wirksame Gradienten-Magnetfeld, der sogenannte Phasenkodierungsgradient, variiert. Bei diesem sogenannten 2DF-Verfahren ist bekanntlich das MR-Signal umso kleiner, je größer der Phasenkodierungsgradient ist, weil dann lediglich noch feine Strukturen in der Schicht einen Beitrag zu dem MR-Signal liefern. Daher geht diejenige Meßschicht am stärksten in die für eine Rekonstruktionsschicht ermittelte Kernmagnetisierungsverteilung ein, die mit einem Phasenkodierungsgradienten von Null aufgenommen wurde - unabhängig davon, ob diese Meßschicht die gleiche Lage hat wie die Rekonstruktionsschicht oder ob sie dieser gegenüber um eine halbe Schichtdicke versetzt ist. Dies führt zu unerwünschten Bildeindrücken.

Aufgabe der vorliegenden Erfindung ist es, ein Verfahren der eingangs genannten Art in dieser Hinsicht zu verbessern. Diese Aufgabe wird erfindungsgemäß dadurch gelöst, daß

- daß die Richtung des Gradienten des während der Erfassung des MR-Signals wirksamen Gradienten-Magnetfeldes von Zyklus zu Zyklus so variiert wird, daß sich die während aller Zyklen gegebenen Richtungen auf einen Winkelbereich von 360° aufteilen, wobei der Richtungsunterschied umso größer ist, je größer der Versatz zwischen den Gruppen von Meßschichten ist, die den Zyklen zugeordnet sind
- und daß die MR-Signale von Meßschichten, die einen geringen Abstand von der Rekonstruktionsschicht haben, mit einem höheren Gewichtungsfaktor in die Rekonstruktion eingehen als die MR-Signale von Meßschichten, die von der Rekonstruktionsschicht einen größeren Abstand haben.

Bei der Erfindung wird anstelle des 2DF-Verfahrens das sogenannte Projektions-Rekonstruktionsverfahren angewandt, bei dem es nach einer Anregung der Kernmagnetisierung keinerlei Phasenkodierungsgradienten gibt, sondern nur einen Lesegradienten, dessen Richtung von Zyklus zu Zyklus geändert wird. Bei diesen Verfahren wird während der Erfassung eines jeden MR-Signals im sogenannten k-Raum ein Pfad durchlaufen, der auch dessen Nullpunkt erreicht, der den niedrigen Ortsfrequenzen, d.h. den großen Bildstrukturen innerhalb der Schicht zugeordnet ist. Dadurch haben anders als beim 2DF-Verfahren alle MR-Signale Information auch über die großflächigen Strukturen im Untersuchungsbereich und damit (zunächst) das gleiche Gewicht.

Dadurch, daß man die MR-Signale bzw. die daraus durch eine inverse Fouriertransformation abgeleiteten Projektionsdaten, die dem Spektrum des MR-Signals entsprechen, entsprechend dem Abstand zwischen der Rekonstruktionsschicht und der Meßschicht, aus der die Projektionsdaten stammen, in der angegebenen Weise wichtet, wird erreicht, daß die Meßschicht, deren Lage am besten mit derjenigen der Rekonstruktionsschicht übereinstimmt, mit einem stärkeren Gewicht eingehen als Meßschichten, deren Mitte sich am Rande der Rekonstruktionsschicht befindet. Obwohl also die Kern-

magnetisierungsverteilung in der Rekonstruktions-schicht aus Signalen bzw. Daten abgeleitet wird, die aus gegeneinander räumlich leicht versetzten Meßschichten gewonnen werden, entspricht die auf diese Weise rekonstruierte Kernmagnetisierungsverteilung recht genau derjenigen, die sich in einer Meßschicht mit dieser Lage ergeben hätte.

Eine bevorzugte Weiterbildung der Erfindung sieht vor, daß die Gewichtungsfaktoren so gewählt sind, daß ihre Summe für MR-Signale, die unter um zumindest annähernd um 180° voneinander differierenden Richtungen des Gradienten-Magnetfeldes erfaßt wurden, zumindest annähernd konstant ist. Diese Weiterbildung vermeidet in Verbindung mit der erfindungsgemäßen Aufteilungen der Gradientenrichtungen auf die Meßschichten, daß streifenartige Artefakte auftreten; derartige Artefakte können bei dem Projektions-Rekonstruktionsverfahren grundsätzlich dann auftreten, wenn einzelne Richtungen gegenüber anderen hervorgehoben werden.

Es sei an dieser Stelle erwähnt, daß es aus einer Veröffentlichung von Rasche et al "Improved Acquisition and Reconstruction schemes in Helical Imaging", in Proceedings, SMR 2nd Meeting, p 787 (1994) bekannt ist, die für die verschiedenen Gradientenrichtungen gewonnenen MR-Signale bzw. die daraus abgeleiteten Projektionsdaten zu gewichten. Allerdings handelt es sich dabei nicht um ein Multislice-Verfahren, sondern um ein Tomographie-Verfahren, bei dem eine einzige räumlich vorgegebene, aber zeitlich (z.B. durch einströmendes Kontrastmittel) veränderliche Schicht untersucht wird.

Eine Anordnung zur Durchführung des Verfahren, die ausgeht von

- einer Hochfrequenzspulenanordnung zur Erzeugung von magnetischen Hochfrequenzimpulsen zwecks Anregung der Kernmagnetisierung in ver-schiedenen Schichten des Untersuchungsberei-ches sowie zum Empfang der danach auftretenden MR-Signale
- einer in ihrer Frequenz steuerbaren, die Mittenfrequenz der Hochfrequenzimpulse bestimmenden Oszillatoranordnung
- einer Gradientenspulenanordnung zur Erzeugung von Gradienten-Magnetfeldern während der Hochfrequenzimpulse sowie während der Erfassung der MR-Signale
- einer Rekonstruktionseinheit zur Rekonstruktion der Kernmagnetisierungsverteilung in einer Rekonstruktionsschicht vorgebbarer Lage aus den MR-Signalen und
- einer programmierbaren Steuereinheit zum Steuern des zeitlichen Verlaufs der Hochfrequenzimpulse und der Gradienten-Magnetfelder

ist erfindungsgemäß dadurch gekennzeichnet

- daß die Steuereinheit so programmiert ist,

- daß während jedes Zyklus pro Meßschicht wenigstens ein Hochfrequenzimpuls mit von Meßschicht zu Meßschicht in Stufen einer ersten Größe geänderter Mittenfrequenz erzeugt wird und die MR-Signale aus den Meßschichten mit einem in der gleichen Richtung verlaufenden Gradienten des Gradienten-Magnetfeldes erfaßt werden
- und daß von Zyklus zu Zyklus die Mittenfrequenzen der Hochfrequenzimpulse in Stufen einer zweiten, im Vergleich zur ersten Größe kleinen Größe versetzt werden und die Richtung des während der Erfassung der MR-Signale wirksamen Gradienten so variiert wird, daß sich die während aller Zyklen gegebenen Richtungen auf einen Winkelbereich von 360° aufteilen,
- und daß die Rekonstruktionseinheit so ausgebildet ist, daß die MR-Signale von Meßschichten, die einen geringen Abstand von der Rekonstruktionsschicht haben, mit einem höheren Gewichtungsfaktor in die Rekonstruktion eingehen als die MR-Signale von Meßschichten, die von der Rekonstruktionsschicht einen größeren Abstand haben.

Die Erfindung wird nachstehend anhand der Zeichnungen näher erläutert. Es zeigen

Fig. 1      ein Kernspintomographie-Gerät, mit dem die Erfindung ausführbar ist,

Fig. 2      ein Blockschaltbild eines solchen Gerätes in schematischer Darstellung,

Fig. 3      den zeitlichen Verlauf verschiedener Signale der Sequenzen von zwei zu unterschiedli-chen Zyklen gehörenden Anregungsse-quenzen,

Fig. 4      die räumliche Lage der Meßschichten bei verschiedenen Zyklen,

Fig. 5      die räumliche Zuordnung der aus den MR-Signalen abgeleiteten Projektionsdaten zum Untersuchungsbereich,

Fig. 6      die Abtastung des K-Raums bei dem erfindungsgemäßen Verfahren,

Fig. 7      die Gradientenrichtung $\alpha$ als Funktion der Lage Meßschichten und

Fig. 8      den zugehörigen Verlauf der Gewichtungsfaktoren.

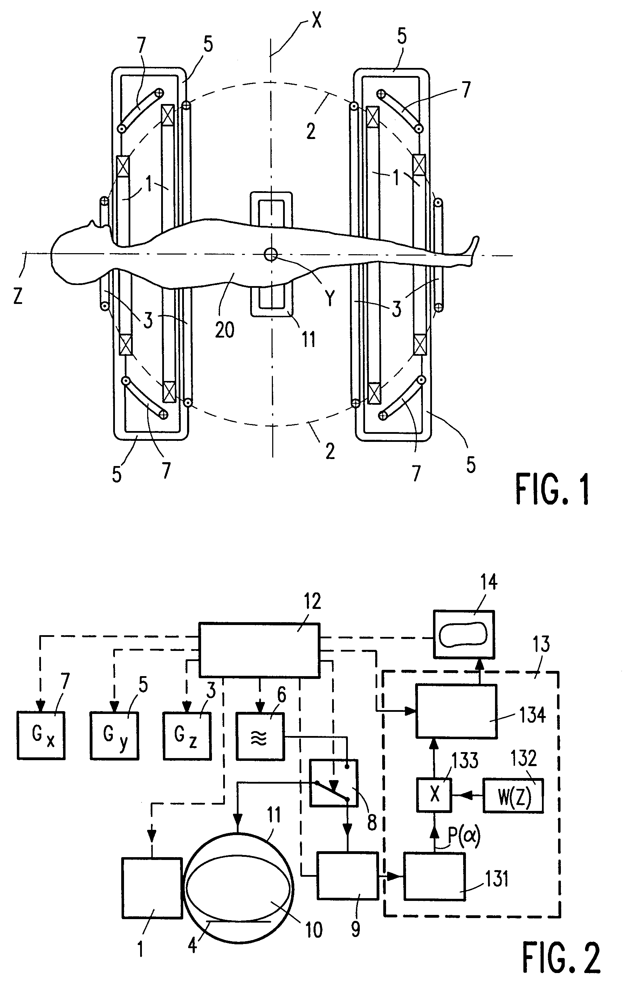

Das in Fig. 1 schematisch dargestellte MR-Gerät besitzt eine aus vier Spulen 1 bestehende Anordnung zur Erzeugung eines homogenen stationären Magnetfeldes, das in der Größenordnung von einigen zehntel Tesla bis einigen Tesla liegen kann. Im Innern dieser Spulen befindet sich der zu untersuchende Patient 10 auf einer Tischplatte 4.

Zur Erzeugung eines in z-Richtung verlaufenden und sich in dieser Richtung linear ändernden Magnetfeldes $G_z$ sind vier Spulen 3 auf der Oberfläche 2 eine Kugel angeordnet. Weiterhin sind vier Spulen 7 vorgesehen, die ein ebenfalls in z-Richtung verlaufendes Magnetfeld $G_x$ erzeugen, das sich linear in x-Richgtung (vertikal) ändert. Ein in z-Richtung verlaufendes Magnetfeld $G_y$, das sich linear in y-Richtung (senkrecht zur Zeichenebene der Fig. 1) ändert, wird von den vier Spulen 5 erzeugt, die mit den Spulen 7 identisch sein können, jedoch diesen gegenüber um 90° versetzt angeordnet sind und von denen nur zwei dargestellt sind. Die von den Gradientenspulen erzeugten Magnetfelder werden im folgenden auch als "Gradienten-Magnetfelder" oder vereinfacht als "Gradient" bezeichnet. Da jede der drei Spulenanordnungen 3, 5 und 7 zur Erzeugung der Gradienten-Magnetfelder symmetrisch zur Kugeloberfläche 2 angeordnet ist, ist die Feldstärke im Kugelzentrum nur durch das stationäre homogene Magnetfeld der Spule 1 bestimmt.

Weiterhin ist eine Hochfrequenzspule 11 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Wie in Fig. 2 dargestellt, ist die Hochfrequenzspule 11 über einen Umschalter 8 wahlweise mit einem Oszillator 6 oder mit einem Empfänger 9 verbunden.

Die Hochfrequenzspule 11 kann in der dargestellten Stellung des Umschalters zum Empfangen der im Untersuchungsbereich erzeugten MR-Signale eingesetzt werden. Es ist jedoch auch möglich, zum Empfang der MR-Signale eine gesonderte, in Fig. 1 nicht näher dargestellte Hochfrequenzempfangsspule zu verwenden.

Die zeitliche Lage der Hochfrequenzimpulse, ihre Bandbreite und ihre Mittenfrequenz sind von einer Steuereinheit 12 steuerbar, die auch den Strom durch die Spulen 1 sowie den zeitlichen Verlauf der magnetischen Gradientenfelder $G_x$, $G_y$ und $G_z$ steuert. Außerdem ist eine Rekonstruktionseinheit 13 vorgesehen, die aus den MR-Signalen die Kernmagnetisierungsverteilung in einer im folgenden als "Rekonstruktionsschicht" bezeichneten Schicht - oder in mehreren solcher Schichten - rekonstruieren und auf einer Ausgabeeinheit 14 darstellen kann.

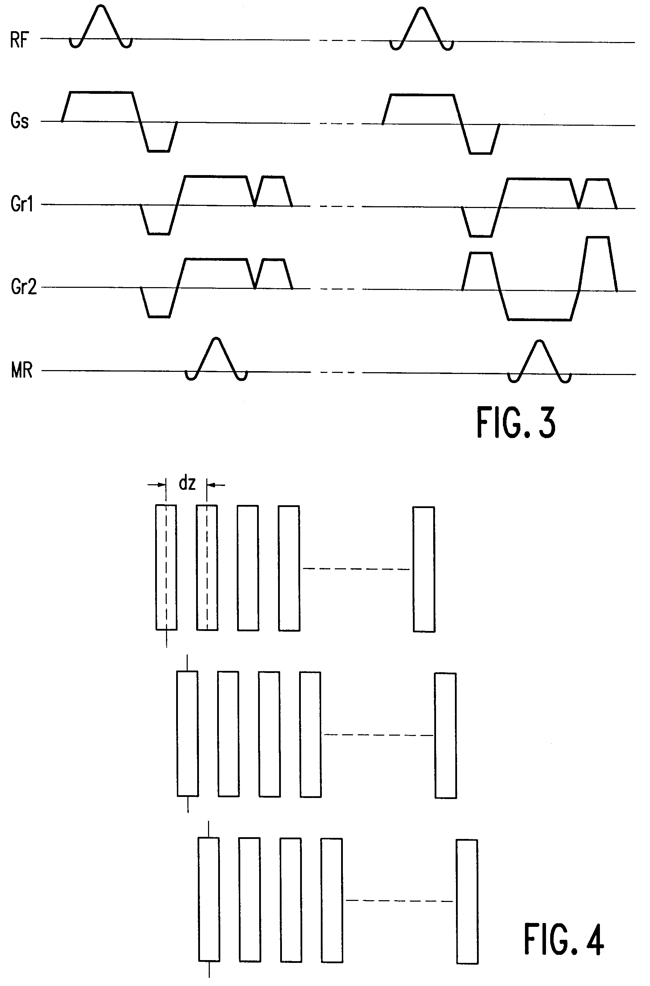

In Fig. 3 ist in der linken und der rechten Hälfte die Lage und der zeitliche Verlauf verschiedener Signale bei zwei - in verschiedenen Anregungszyklen wirksamen - Sequenzen nach der Erfindung dargestellt. Die erste Zeile zeigt die Lage und den zeitlichen Verlauf der Umhüllenden der Hochfrequenzimpulse RF. Die zweite bis vierte Zeile zeigen den Verlauf dreier magnetischer Gradientenfelder, wobei in der zweiten Zeile der Verlauf eines Gradientenfeldes $G_s$ dargestellt ist, das während des Hochfrequenzimpulses RF wirksam ist und das z.B. in z-Richtung verlaufen kann ($G_s = G_z$), während in der dritten und vierten Zeile der Verlauf zweier magnetischer Gradientenfelder dargestellt ist, die während der Erfassung des MR-Signals - in der fünften Zeile dargestellt - wirksam sind und die deshalb als "Lesegradient" $G_{r1}$ und $G_{r2}$ bezeichnet werden.

Durch den während des Hochfrequenzimpulses RF wirksamen Gradienten $G_s$ wird bewirkt, daß die Kernmagnetisierung nur in einer bestimmten Schicht (zur besseren Unterscheidung wird diese Schicht im folgenden als "Meßschicht" bezeichnet, während eine Schicht in der anschließend die Kernmagnetisierungsverteilung rekonstruiert wird, "Rekonstruktionsschicht" heißen soll) angeregt wird, deren Lage von der Mittenfrequenz des Hochfrequenzimpulses abhängt. Das dabei entstehende MR-Signal wird während des zweiten von drei Abschnitten erfaßt, aus denen sich die Lesegradienten $G_{r1}$, $G_{r2}$ zusammensetzen, die senkrecht zum Gradienten $G_s = G_z$ verlaufen, wobei beispielsweise $G_{r1} = G_x$ und $G_{r2} = G_y$ ist. Der erste Abschnitt der Lesegradienten $G_{r1}$ und $G_{r2}$ hat die entgegengesetzte Polarität wie der zweite, und das zeitliche Integral darüber ist nur halb so groß wie das zeitliche Integral über den zweiten Abschnitt. Dadurch wird erreicht, daß bei der Erfassung des MR-Signals im k-Raum ein geradliniger Pfad durchlaufen wird, der in der Mitte des zweiten Abschnittes den Nullpunkt des k-Raums durchläuft, weshalb das MR-Signal zu diesem Zeitpunkt ein Maximum erreicht. Der auf den zweiten Abschnitt folgende dritte Abschnitt ist so bemessen, daß das zeitliche Integral über alle drei Abschnitte des betreffenden Lesegradienten stets einen konstanten Wert annimmt.

Die in der linken Hälfte von Fig. 3 dargestellte Sequenz wird in dem betreffenden Zyklus entsprechend der Zahl der anzuregenden Schichten wiederholt, d.h. für s anzuregende Schichten werden pro Zyklus s Sequenzen erzeugt. Von Wiederholung zu Wiederholung wird dabei lediglich die Mittenfrequenz des vom Oszillator 6 gelieferten Hochfrequenzimpulses RF in Stufen der Größe df geändert, wobei df größer sein muß als die Bandbreite des Hochfrequenzimpulses RF. Dadurch wird erreicht, daß die innerhalb eines Zyklus angeregten Schichten gegeneinander versetzt sind und sich nicht überlappen. Dies ist erforderlich, damit die Kernmagnetisierung einer Schicht innerhalb eines Zyklus nur durch eine einzige Sequenz angeregt wird.

Die folgenden Zyklen unterscheiden sich von dem jeweils vorangehenden Zyklus in zwei Punkten:

a) Von Zyklus zu Zyklus werden die Mittenfrequenzen der Hochfrequenzimpulse um einen Betrag $\Delta f$ geändert, wobei die Beziehung gilt
$\Delta f = df/N$, wobei N die Zahl der Zyklen ist. Der Frequenzabstand df zwischen den Mittenfrequenzen der Hochfrequenzimpulse bleibt aber unverändert.
b) Von Zyklus zu Zyklus wird auch die Richtung des Lesegradienten geändert. Dies erfolgt, indem Größe und/oder Polarität wenigstens eines der beiden Gradienten $G_{r1}$ oder $G_{r2}$ während des zweiten Abschnitts (und damit auch während des ersten Abschnitts) geändert wird, woraus sich eine Richtungsänderung ergibt, da $G_{r1}$ und $G_{r2}$ zueinander senkrecht stehen. Wenn die Kernmagnetisierungsverteilung aus N MR-Signalen rekonstruiert werden soll, sollte die Richtungsänderung 360°/N betragen.

Die Richtung der Lesegradienten $G_{r1}$, $G_{r2}$ und die Frequenzänderung bzw. der dadurch bewirkte räumliche Versatz der angeregten Meßschichten um dz/N sollten dabei einander so zugeordnet sein, daß mit zunehmendem Versatz der Meßschichten die Richtungsänderung des Lesegradienten monoton zu- oder abnimmt.

Fig. 4 zeigt für drei verschiedene Zyklen die Lage der Schichten, deren Kernmagnetisierung nacheinander angeregt wird. Die erste Reihe stellt diese Lage beim ersten Zyklus dar, die zweite Reihe den Zustand bei etwa n/2 Zyklen und die letzte Reihe den Zustand im n-ten-Zyklus, d.h. im letzten Zyklus. Der Abstand zweier benachbarter, innerhalb eines Zyklus angeregter Schichten, d.h. der Abstand ihrer Mittelebenen voneinander beträgt dz. Dieses gilt für alle Zyklen. Von Zyklus zu Zyklus ergibt sich jedoch ein Versatz sämtlicher Schichten gegenüber ihrer vorherigen Position um die Strecke dz/N, so daß nach der Hälfte der Zyklen die erste Schicht der angeregten Gruppe von Schichten sich an einer Position befindet, die etwa in der Mitte zwischen der ersten und zweiten Schicht beim ersten Zyklus liegt. Im letzten Zyklus hat die erste Schicht der Gruppe nahezu die Position erreicht, die im ersten Zyklus von der zweiten Schicht eingenommen wurde.

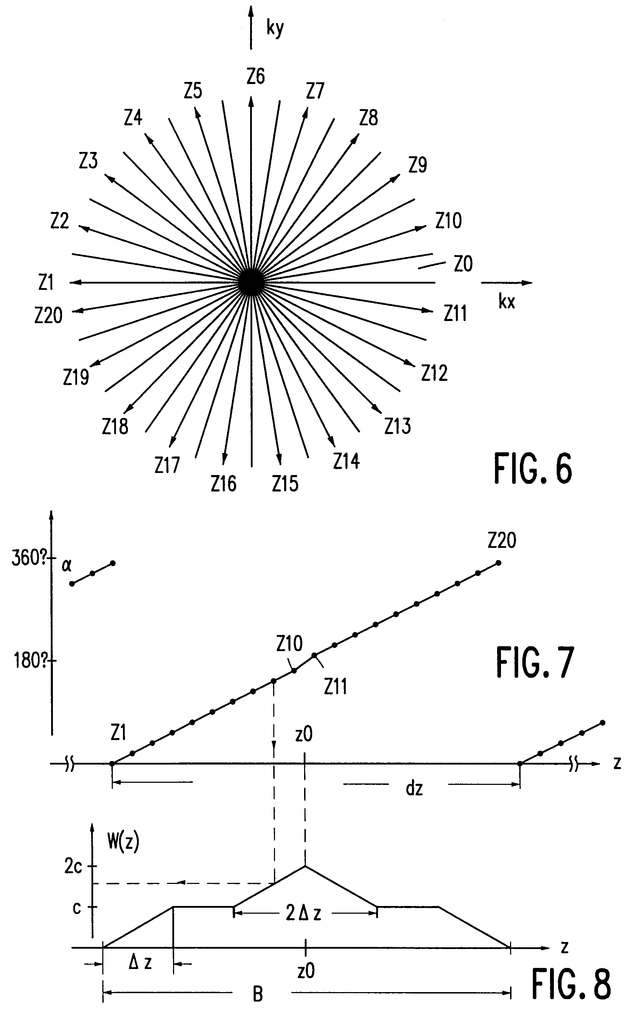

Fig. 6 erläutert, wie bei den verschiedenen Zyklen der k-Raum abgetastet wird (der k-Wert eines einzelnen Abtastwertes eines MR-Signals entspricht bekanntlich dem zeitlichen Integral über die Gradientenmagnetfelder von der Anregung bis zur Erfassung des betreffenden Abtastwertes). Jedes MR-Signal wird längs eines Pfades erfaßt, der einem Strahl durch den Nullpunkt des k-Raums entspricht. Wenn - wie bei Fig. 3 vorausgesetzt - das zeitliche Integral über den ersten Abschnitt des Lesegradienten $G_{r1}$ bzw. $G_{r2}$ halb so groß ist wie das zeitliche Integral über dessen zweiten Abschnitt, haben die Enden dieser Strahlen von dem Nullpunkt den gleichen Abstand, so daß sich das dargestellte Muster ergibt. Ein Pfeil gibt dabei die Richtung an, in der der k-Raum jeweils durchlaufen wird. Es entstehen somit N Strahlen durch den Nullpunkt des k-Raums, wobei für Fig. 6 gilt N = 20.

Jeder Strahl ist mit einer Angabe z1 .... z20 versehen, die die räumliche Lage einer der Meßschichten kennzeichnet, die durch einen Zyklus angeregt werden, z.B. die Lage der ersten Meßschicht. Dabei gilt, daß zi (i = 1 . . . 20) umso größer ist, je größer i ist. Man erkennt, daß bei den ersten zehn (=N/2)) Zyklen sich die Richtung der Strahlen im k-Raum (und damit die Richtung der Lesegradienten im Raum) von Zyklus zu Zyklus jeweils um 360°/N ändert, so daß gegenüber dem Strahl für den ersten Zyklus (z1) der Strahl (z10) für den zehnten Zyklus um 180°-360°/N und für den darauffolgenden Zyklus (z11) um 180° + 360°/2N gedreht ist. Für die darauffolgenden Zyklen ergibt sich wiederum das Winkelinkrement 360°/N. Auf diese Weise wird der k-Raum für eine gerade Zahl von N Zyklen gleichmäßig abgetastet (bei einer ungeraden Zahl ergibt sich eine gleichmäßige Abtastung noch einfacher durch ein Winkelinkrement 360°/N von Zyklus zu Zyklus).

Fig. 7 zeigt die resultierende Zuordnung zwischen der Richtung $\alpha$ des Lesegradienten und der Lage z einer bestimmten Meßschicht (z. B. der zweiten). Man erkennt diese Zuordnung teilweise auch noch für die beiden benachbarten Schichten.

Zur Rekonstruktion der Kernmagnetisierungsverteilung in einer bei z0 liegenden Rekonstruktionsschicht werden die Projektionsdaten von jeweils N/2 (=10) räumlich aufeinanderfolgenden und in unterschiedlichen Zyklen gewonnenen Meßschichten beiderseits von z0 herangezogen. Die Rekonstruktion mit den auf diese Weise gewonnenen Daten geht in der Rekonstruktionseinheit 13 (Fig. 2) auf folgende Weise vor sich:

Jedes im Empfänger 9 in dem Niederfrequenzbereich umgesetzte und digitalisierte, am Empfängerausgang als Folge digitaler Abtastwerte vorliegende MR-Signal wird im Block 131 einer inversen Fouriertransformation unterzogen. Die dadurch entstehenden Projektionsdaten $P(\alpha)$ werden in einem Block 133 mit einem aus einem Speicher 132 geladenen Gewichtungsfaktor W(z) multipliziert. Die auf diese Weise gewichteten Projektionsdaten werden in Block 134 einer Rückprojektion (back-projection) unterzogen, wie sie auch in der Röntgencomputertomographie üblich ist, woraus sich ein Bild der Kernmagnetisierungsverteilung in der Rekonstruktionsschicht ergibt.

Die Blöcke 131 ... 134 sind in Fig. 2 nach Art einer Hardware-Konfiguration dargestellt, doch ist es für den Fachmann klar, daß er die Rekonstruktionseinheit auch durch ein programmierbares Prozessor-System realisieren kann, das die MR-Daten in der durch die Blöcke 131 ... 134 angedeuteten Art und Weise verarbeitet.

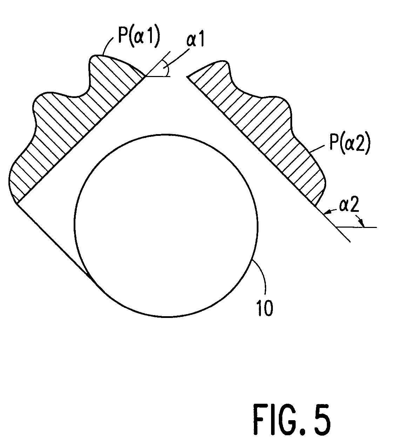

Die durch die Fouriertransformation im Block 131 erzeugten Projektionsdaten entsprechen dem Spektrum des MR-Signals bzw. einer Projektion $P(\alpha)$ der Kernmagnetisierungsverteilung in der Richtung $\alpha$ des Lesegradienten. $P(\alpha)$ entspricht also dem Linienintegral der Kernmagnetisierungsverteilung entlang von Geraden, die in Richtung $\alpha$ verlaufen. Fig. 5 zeigt für zwei verschiedene Gradientenrichtungen $\alpha 1$ und $\alpha 2$, die von einer Schicht gewonnenen Projektionsdaten $P(\alpha 1)$ und $P(\alpha 2)$. Diese Projektionsdaten unterscheiden sich zwar für verschiedene Richtungen $\alpha 1$ und $\alpha 2$, jedoch ist das Integral senkrecht zur Richtung $\alpha$ über die Projektionsdaten (d.h. die schraffierte Fläche in Fig. 5) bei einem vorgegebenen Objekt für alle Richtungen gleich.

Die Projektionsdaten $P(\alpha)$ für einen bestimmten Winkel $\alpha$ des Lesegradienten (bzw aus einem bestimmten Zyklus), die in dem Diagramm der Fig. 7 durch jeweils einen Punkt gekennzeichnet sind, werden mit dem Gewichtungsfaktor multipliziert, der sich aus der darunter befindlichen Gewichtungsfaktorkurve W(z) der Fig. 8 ergibt, wie durch gestrichelte Linien angedeutet. Die Gewichtungsfaktorkurve ist in einem Bereich B definiert (verschieden von Null), der dem Abstand dz zweier benachbarter, innerhalb eines Meßzyklus angeregter Meßschichten entspricht. Für den Wert z0 der Rekonstruktionsschicht hat W(z) ein Maximum 2c, wobei c eine Konstante ist, z.B. 1. In einem Bereich $\Delta z$ beiderseits die-

ses Maximums ändert sich der Gewichtungsfaktor linear auf einen Wert c. Der Gewichtungsfaktor bleibt dann konstant (= c) bis zu einem Abstand $\Delta z$ von den Rändern des Definitionsbereiches. Von da an nimmt er linear auf Null ab.

Bei der in Fig. 6 und 7 angedeuteten Lage von z0 gehen die Projektionsdaten der Meßschichten z10 und z11 mit einem Gewichtungsfaktor von nahezu 2c in die Rückprojektion ein, während die Projektionsdaten der an den Rändern des Definitionsbereiches B befindlichen Meßschichten z1 und z20 mit einem Gewichtungsfaktor von fast Null eingehen. Weil die weiter entfernten Schichten z1 und z20 wesentlich weniger zur Rekonstruktion beitragen als die unmittelbar benachbarten Meßschichten z1 und z11, ergibt sich eine schärfere Abbildung.

Wichtig ist dabei, daß durch den angegebenen Verlauf der Gewichtungsfaktorkurve W(z) sichergestellt ist, daß die Summe der Gewichtungsfaktoren für zwei um 180° versetzte Schichten eine Konstante ist. So ist beispielsweise die Summe der Gewichtungsfaktoren für die Meßschichten z1 und z11, die mit einem nahezu um 180° gegeneinander versetzten Lesegradienten gemessen wurden, etwa genauso groß wie die Summe der Gewichtungsfaktoren der Meßschichten z6 und z16, die ebenfalls mit zwei um nahezu 180° versetzten Richtungen des Lesegradienten gemessen wurden. Alle Richtungen gehen daher mit dem gleichen Gewicht in die Rekonstruktion ein (die Projektionsdaten einer Meßschicht für um 180° versetzte Lesegradienten sind identisch), so daß bei der Rekonstruktion die streifenartigen Artefakte vermieden werden, die bei einer unterschiedlichen, richtungsabhängigen Wichtung der Projektionsdaten auftreten können.

Bei dem Ausführungsbeispiel nach Fig. 7 fällt die Lage z0 der Rekonstruktionsschicht zufällig genau mit der Mitte des Bereichs zusammen, innerhalb dessen sich die Lage einer bestimmten Meßschicht von Zyklus zu Zyklus verschiebt. Wenn diese Voraussetzung nicht erfüllt ist, wird die Gewichtungsfaktorkurve (Fig. 8) entsprechend z0 verschoben, und es werden die Daten zur Rekonstruktion herangezogen, die sich in Fig. 7 oberhalb der verschobenen Kurve W(z) befinden.

Bei den in Fig. 3 dargestellten Sequenzen wurde davon ausgegangen, daß dem zweiten Abschnitt des Lesegradienten, während dessen das MR-Signal erfaßt wird, ein erster Abschnitt vorhergeht, dessen zeitliches Integral halb so groß ist wie das des zweiten. Dieser erste Gradientenabschnitt kann aber auch entfallen. Daraus ergibt sich der Vorteil, daß der zeitliche Abstand zwischen der Anregung einer Schicht und dem Erfassen des MR-Signals verkürzt werden kann, so daß sich dieses Verfahren für einen Untersuchungsbereich vergleichsweise inhomogenen stationären Hauptmagnetfeld eignet. Da dann im k-Raum jeweils nur ein von dessen Nullpunkt ausgehender Radius abgetastet wird, muß die Zahl der Zyklen verdoppelt werden, wenn die gleiche räumliche Auflösung erreicht werden soll wie bei einem Verfahren, bei dem der Nullpunkt des k-Raums in der Mitte des doppelt so langen Strahls liegt.

Zwei um 180° gegeneinander versetzte Radien entsprechen dabei einem einzigen Strahl nach Fig. 6. Diese beiden einander entgegengesetzten Richtungen sollten möglichst in unmittelbar aufeinanderfolgenden Zyklen erfaßt werden, wobei entweder in beiden Zyklen dieselbe Gruppe von Meßschichten - also ohne räumlichen Versatz - oder aber eine demgegenüber nur um dz/2N versetzte Gruppe von Meßschichten angeregt wird.

**Patentansprüche**

1. MR-Verfahren mit einer Anzahl von Zyklen

   - wobei in jedem Zyklus nacheinander in mehreren, im Abstand voneinander befindlichen, jeweils eine Gruppe bildenden Meßschichten die Kernmagnetisierung angeregt und die unter dem Einfluß wenigstens eines Gradienten-Magnetfeldes erzeugten MR-Signale erfaßt werden,
   - wobei die durch verschiedene Zyklen angeregten Gruppen von Meßschichten gegeneinander einen räumlichen Versatz aufweisen, der kleiner ist als der Abstand der durch einen Zyklus angeregten Meßschichten
   - wobei von Zyklus zu Zyklus die Gradienten-Magnetfelder variiert werden
   - und wobei die Kernmagnetisierungsverteilung in einer Rekonstruktionsschicht aus den in den unterschiedliche Zyklen erfaßten MR-Signalen von räumlich benachbarten und beiderseits der Rekonstruktionsschicht befindlichen Meßschichten rekonstruiert wird,

   <u>dadurch gekennzeichnet,</u>

   - daß die Richtung ($\alpha$) des Gradienten des während der Erfassung des MR-Signals wirksamen Gradienten-Magnetfeldes ($G_{r1}$, $G_{r2}$) von Zyklus zu Zyklus so variiert wird, daß sich die während aller Zyklen gegebenen Richtungen ($\alpha$) auf einen Winkelbereich von 360° aufteilen, wobei der Richtungsunterschied umso größer ist, je größer der Versatz zwischen den Gruppen von Meßschichten ist, die den Zyklen zugeordnet sind
   - und daß die MR-Signale bzw. die daraus abgeleiteten Projektionsdaten ($P(\alpha)$) von Meßschichten ($z_{10}$,$z_{11}$), die einen geringen Abstand von der Rekonstruktionsschicht haben, mit einem höheren Gewichtungsfaktor (W(z))in die Rekonstruktion eingehen als die MR-Signale bzw. Projektionsdaten von Meßschichten ($z_1$,$z_{20}$) die von der Rekonstruktionsschicht ($z_0$) einen größeren Abstand haben.

2. MR-Verfahren nach Anspruch 1, <u>dadurch gekennzeichnet,</u> daß die Gewichtungsfaktoren (W(z) so gewählt sind, daß ihre Summe für MR-Signale (z.B. $z_1$, $z_{11}$) die unter um zumindest annähernd um 180° voneinander differierenden Richtungen des Gradienten-Magnetfeldes erfaßt wurden, zumindest annähernd konstant ist.

3. MR-Anordnung zur Durchführung des Verfahrens nach Anspruch 1 mit

- einer Hochfrequenzspulenanordnung (11) zur Erzeugung von magnetischen Hochfrequenzimulsen zwecks Anregung der Kernmagnetisierung in verschiedenen Schichten des Untersuchungsbereiches sowie zum Empfang der danach auftretenden MR-Signale
- einer in ihrer Frequenz steuerbaren, die Mittenfrequenz der Hochfrequenzimpulse bestimmenden Oszillatoranordnung (6)
- einer Gradientenspulenanordnung (3,5,7) zur Erzeugung von Gradienten-Magnetfeldern ($G_s$, $G_{r1}$, $G_{r2}$) während der Hochfrequenzimpulse sowie während der Erfassung der MR-Signale
- einer Rekonstruktionseinheit (13) zur Rekonstruktion der Kernmagnetisierungsverteilung in einer Rekonstruktionsschicht vorgebbarer Lage ($z_o$) aus den MR-Signalen und
- einer programmierbaren Steuereinheit (12) zum Steuern des zeitlichen Verlaufs der Hochfrequenzimpulse und der Gradienten-Magnetfelder

dadurch gekennzeichnet,

- daß die Steuereinheit (12) so programmiert ist,

  - daß während jedes Zyklus pro Meßschicht wenigstens ein Hochfrequenzimpuls (RF) mit von Meßschicht zu Meßschicht in Stufen (df) einer ersten Größe geänderter Mittenfrequenz erzeugt wird und die MR-Signale aus den Meßschichten mit einem in der gleichen Richtung ($\alpha$) verlaufenden Gradienten des Gradienten-Magnetfeldes erfaßt werden
  - und daß von Zyklus zu Zyklus die Mittenfrequenzen der Hochfrequenzimpulse in Stufen ($\Delta$) einer zweiten, im Vergleich zur ersten Größe kleinen Größe versetzt werden und die Richtung ($\alpha$) des während der Erfassung der MR-Signale wirksamen Gradienten so variiert wird, daß sich die während aller Zyklen gegebenen Richtungen auf einen Winkelbereich von 360° aufteilen,
  - und daß die Rekonstruktionseinheit (13) so ausgebildet ist, daß die MR-Signale bzw. die Projektionsdaten ($P(\alpha)$) von Meßschichten, die einen geringen Abstand von der Rekonstruktionsschicht haben, mit einem höheren Gewichtungsfaktor ($W(z)$ in die Rekonstruktion eingehen als die MR-Signale von Meßschichten, die von der Rekonstruktionsschicht einen größeren Abstand haben.

FIG. 1

FIG. 2

8

FIG. 3

FIG. 4

FIG. 5

FIG. 6

FIG. 7

FIG. 8

Europäisches
Patentamt

**EUROPÄISCHER RECHERCHENBERICHT**

Nummer der Anmeldung

EP 95 20 2622

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | US-A-4 999 580 (C.H. MEYER ET AL.) <br> * Zusammenfassung * <br> * Spalte 2, Zeile 5 - Zeile 66 * <br> * Spalte 4, Zeile 31 - Spalte 5, Zeile 68 * <br> * Spalte 13, Zeile 54 - Spalte 14, Zeile 28 * <br> --- | 1,3 | G01R33/54 <br> G01R33/561 <br> G01R33/565 |
| A,D | US-A-5 298 862 (J. HENNIG) <br> * Spalte 1, Zeile 12 - Spalte 2, Zeile 62 * <br> * Spalte 3, Zeile 37 - Spalte 4, Zeile 58 * <br> --- | 1,3 | |
| A | MAGNETIC RESONANCE IN MEDICINE., <br> Bd.6, Nr.3, März 1988, DULUTH,MN US <br> Seiten 364 - 371 <br> S. MÜLLER 'MULTIFREQUENCY SELECTIVE RF PULSES FOR MULTISLICE MR IMAGING' <br> * das ganze Dokument * <br> --- | 1,3 | |
| A | US-A-4 843 322 (G.H. GLOVER) <br> * Spalte 2, Zeile 25 - Spalte 4, Zeile 10 * <br> * Spalte 9, Zeile 11 - Spalte 12, Zeile 17 * <br> --- | 1,3 | **RECHERCHIERTE SACHGEBIETE (Int.Cl.6)** <br> G01R |
| A | DE-A-42 16 969 (A. HAASE) <br> * Zusammenfassung * <br> * Spalte 1, Zeile 3 - Spalte 2, Zeile 60 * <br> --- | 1,3 | |
| A | US-A-4 727 325 (S. MATSUI ET AL.) <br> * Zusammenfassung * <br> * Spalte 1, Zeile 23 - Zeile 68 * <br> * Spalte 2, Zeile 48 - Spalte 6, Zeile 51 * <br> --- <br> -/-- | 1,3 | |

Der vorliegende Recherchenbericht wurde für alle Patentansprüche erstellt

| Recherchenort | Abschlußdatum der Recherche | Prüfer |
|---|---|---|
| DEN HAAG | 19. Dezember 1995 | Horak, G |

EPO FORM 1503 03.82 (P04C03)

Europäisches
Patentamt

**EUROPÄISCHER RECHERCHENBERICHT**

Nummer der Anmeldung

EP 95 20 2622

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A,P | EP-A-0 637 756 (TOSHIBA AMERICAN MRI, INC.)<br>* Spalte 1, Zeile 11 - Spalte 2, Zeile 24 *<br>* Spalte 5, Zeile 35 - Spalte 7, Zeile 45 *<br><br>----- | 1,3 | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| DEN HAAG | 19. Dezember 1995 | Horak, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
...................................................................................
& : Mitglied der gleichen Patentfamilie, übereinstimmendes Dokument

EPO FORM 1503 03.82 (P04C03)